Europäisches Patentamt

European Patent Office

Office européen des brevets

(11) Publication number: **0 411 119 A1**

(12) **EUROPEAN PATENT APPLICATION**
published in accordance with Art. 158(3) EPC

(21) Application number: 88903363.5

(22) Date of filing: 08.04.88

(86) International application number: PCT/JP88/00358

(87) International publication number: WO 89/09958 (19.10.89 89/25)

(51) Int. Cl.⁵: **G06F 1/00, H01L 23/46**

(43) Date of publication of application: 06.02.91 Bulletin 91/06

(84) Designated Contracting States: **DE NL**

(71) Applicant: **HITACHI, LTD.**
**6, Kanda Surugadai 4-chome**
**Chiyoda-ku, Tokyo 100(JP)**

(72) Inventor: **ITOH, Masahiko**
**232-1, Kamesaku-cho Hitachiohta-shi**
**Ibaraki 313(JP)**
Inventor: **KOBAYASHI, Shiro**
**19-1-402, Ishinazaka-cho 1-chome**
**Hitachi-shi Ibaraki 319-12(JP)**
Inventor: **FURUTANI, Yasumasa**
**287, Takaba Katsuta-shi**
**Ibaraki 312(JP)**

(74) Representative: **Patentanwälte Beetz sen. - Beetz jun. Timpe - Siegfried - Schmitt-Fumian**
**Steinsdorfstrasse 10**
**D-8000 München 22(DE)**

(54) SEMICONDUCTOR MODULE, ITS COOLING SYSTEM AND COMPUTER USING THE COOLING SYSTEM.

(57) This invention relates to a semiconductor module equipped with means for sealing an inert gas into a housing, storing therein hermetically a semiconductor chip and a cooling structure member, at a pressure equal to, or higher than, the pressure of cooling water, and for detecting an extremely small amount of gas leaking into the cooling water, at an early stage. The module can detect pin-holes generated by corrosion of the cooling structure member at an early stage through the leaking of the inert gas into the cooling water, and prevents the leaking of water to the outside of the cooling structure member. Furthermore, the present invention relates to the provision of an alarm device to prevent any accident of the semiconductor module caused by the leaking of the cooling water, a cooling system for stopping the operation of semiconductor devices on the basis of an alarm from the alarm device and a computer using the cooling system. The present invention provides an inert gas supply port in the housing, introduces the gas into the supply port and can inspect the joint portions of the cooling structure member.

FIG. 1

# SEMICONDUCTOR MODULE, COOLING SYSTEM THEREOF AND ASSOCIATED COMPUTER

[Technical Field]

The present invention is generally directed to a semiconductor module equipped with a cooling system for cooling a semiconductor chip such as an LSI element, and more particularly, to a highly reliable semiconductor module for preventing a water leakage from a cooling structure, its maintenance system, a computer utilizing this system and also a checking method thereof. [Background Art]

One typical arrangement of a conventional semiconductor module incorporating a semiconductor chip such as an LSI is that a package for packaging chips is fitted with fins for preventing an increase in temperature which is due to emission of heat from the chips, and the air is blown by a fan for cooling, thus providing forced-air cooling. An amount of the heat evolved, however, gradually increases because of high integration of chips and highly-densified packaging, and it is difficult to hold the chips at an allowable temperature or under in the air cooling system. A water cooling system which yields a high cooling efficiency was proposed in Japanese Patent Publication No. 56-31743. The most practical and highly efficient water cooling system is arranged such that a cooling structure is provided on semiconductor chips, and water cooling is effected by flowing the water therethrough.

In addition, one of other proposed water cooling structure units is, as disclosed in Japanese Patent Laid-Open No. 61-276242, composed of a cooling structure including a flexible metal bellows and a cap, and of a housing formed with a water-conveyance passageway and accommodating a temperature sensor. Japanese Patent Laid-Open No. 60-160150 discloses a water cooling structure unit which comprises a flexible metal bellows, a heat transmission plate and a cooling water supplying/discharging header.

Besides, there arises a problem inherent in the semiconductor chip incorporating the water cooling structure unit, in which an electrical trouble happens if the cooling water leaks out due to corrosion of the water cooling structure unit. To cope with this, there was proposed a cooling structure in Japanese Patent Laid-Open No. 61-77351, the arrangement being such that a bonded part of the cooling structure is mounted with a sacrifice anode ring for preventing the corrosion due to contact with a heterogeneous metal.

The above-mentioned prior art gives sufficient considerations to the structure of the flexible bellows for enhancing the cooling efficiency of the semiconductor chip and for absorbing thermal deformation thereof. Whereas in connection with the corrosion of the cooling structure, the considerations are insufficient. To be specific, minute holes are formed because of the corrosion of the cooling structure, and the cooling water leaks out. The semiconductor chip and a substrate will be electrically short-circuited due to the contact therewith, resulting in such a serious trouble that a semiconductor module is destroyed. Nevertheless, almost no countermeasure is provided in this respect.

In other words, where the minute holes are formed in the cooling structure due to the corrosion thereof, no attention is paid to means for quickly detecting this condition and preventing the leakage of the cooling water from the minute through-holes.

Accordingly, it is a primary object of the present invention, which obviates the foregoing problems peculiar to the prior art, to provide a semiconductor module capable of preventing a leakage of cooling water from minute through-holes formed both in a cooling structure and a connecting part thereof due to corrosion, a cooling method, a system, a computer associated therewith and a method of checking the semiconductor module. [Disclosure of Invention]

According to one aspect of the invention there is provided a semiconductor module comprising: a semiconductor element; a cooling structure for cooling the semiconductor element with a liquid refrigerant carrier; and a housing for accommodating the semi-conductor element and the cooling structure as well, characterized in that the housing is filled with a gas having a higher pressure than that of the refrigerant carrier, or which is in turn sealed therein.

In accordance with the present invention the housing is formed with a gas inlet for introducing the gas thereinto.

According to another aspect of the invention, there is provided a method of cooling a semiconductor module including: a semiconductor element; a cooling structure for cooling the semiconductor element with a liquid refrigerant carrier; and a housing for accommodating the semiconductor element and the cooling structure, comprising the steps of: detecting corrosion caused due to the refrigerant carrier at a pin-hole stage; and preventing a leakage of the refrigerant carrier outwardly of the cooling structure.

According to still another aspect of the invention, there is provided a semiconductor module cooling system comprising: a semiconductor module including a semiconductor element, a cooling structure for cooling the semiconductor element and the cooling structure with a liquid refrigerant carrier, and a housing for accommodating the semiconductor and the cooling structure; a refrigerant carrier supplying means for supplying the liquid refrigerant carrier to the cooling structure; and a gas supplying means for supplying the housing with a gas having a higher pressure than that of the refrigerant carrier. According to a further aspect of invention, there is provided a semiconductor module cooling system comprising: a semiconductor module including a semiconductor element, a cooling structure for cooling the semiconductor element with a liquid refrigerant carrier, and a housing for accommodating the semiconductor element and the cooling structure; a refrigerant carrier supplying means for supplying the refrigerant carrier to the cooling structure; and a means for detecting a gas leakage into the cooling structure.

According to still a further aspect of the invention, there is provided a semiconductor module cooling system comprising: a semiconductor module including a semiconductor element, a cooling structure for cooling the semiconductor element with a liquid refrigerant carrier, and a housing for accommodating the semiconductor element and the cooling structure; a refrigerant carrier supplying means for supplying the liquid refrigerant carrier to the cooling structure; a gas supplying means for supplying the housing with a gas having a higher pressure than that of the liquid refrigerant carrier; and a sensor for detecting the gas contained in the refrigerant carrier which has been discharged from the cooling structure.

According to yet another aspect of the invention, there is provided a semiconductor module cooling system for cooling a semiconductor module including a semiconductor element, a cooling structure for cooling the semiconductor element with a liquid refrigerant carrier, and a housing for accommodating the semiconductor element and the cooling structure, comprising: a means for detecting pin-holes formed due to corrosion in parts, which are in contact with the liquid refrigerant carrier, of the cooling structure and of connecting portions between the same structure and other members before the liquid refrigerant carrier leaks outside the cooling structure, characterized in that the semiconductor module further includes a means for detecting variations in pressure within the housing or the cooling structure.

According to yet a further aspect of the invention, there is provided a semiconductor module maintenance system comprising: a semiconductor element; a cooling structure for cooling the semiconductor element with a liquid refrigerant carrier; and a housing for accommodating the semiconductor element and the cooling structure, characterized in that a gas contained in the refrigerant carrier leaking from the cooling structure is detected, an operation of the semiconductor element is stopped in advance of the leakage of the refrigerant carrier into the housing, and there is further provided a refrigerant carrier leakage alarming means for giving an alarm by detecting the gas which has leaked into the cooling structure.

According to an additional aspect of the invention, in a computer having: a semiconductor module including a semiconductor element, a cooling structure for cooling the semiconductor element with a liquid refrigerant carrier, and a housing for hermetically sealing the semiconductor element and the cooling structure; a heat exchanger for effecting a heat exchange with other refrigerant carriers for cooling the foregoing liquid refrigerant carrier; a circulation pump for forcibly circulating the liquid refrigerant carrier; and a purifying unit for purifying the liquid refrigerant carrier, there is provided an improvement characterized by comprising: a gas supplying means for keeping a gas at a higher pressure than that of the liquid refrigerant carrier in the housing; a gas extracting tank for extracting the gas which has permeated into the liquid refrigerant carrier; and a gas sensor for detecting the extracted gas.

In accordance with the present invention, the cooling structure is arranged in such a way that a cooling plate connected by a laminate bellows is brought into contact with or connected to the semiconductor element which is then cooled by circulating the refrigerant carrier within the bellows. The cooling structure is 30 $\mu$m or under in thickness. The computer is equipped with an alarming unit for issuing an alarm on the basis of a signal detected by the gas sensor.

According to a still additional aspect of the invention, there is provided a method of checking a semiconductor module including a semiconductor element, a cooling structure for cooling the semiconductor element with a liquid refrigerant carrier, and a housing for accommodating the semiconductor element and the cooling structure, comprising the steps of: injecting a gas into the cooling structure or the housing; and detecting pin-holes formed in the cooling structure by detecting a gas leakage into the cooling structure or the housing. The semiconductor module checking method further comprises the steps of: injecting a first gas into the cooling structure and a second gas into the housing, respectively; and detecting the pin-holes formed in the cooling structure by detecting a leakage of any one of the foregoing gases. In particular, the detection of permeation of the second gas into the first gas preferably prevents deformation of the cooling structure because of the detection associated with an internal pressure.

A gas, particularly an inert gas charged or sealed or press-fed in the tightly closed housing is helt at a higher pressure than a pressure of cooling water flowing within the cooling structure. With this arrangement, even if there are formed minute through-holes (pin-holes) due to the corrosion which do not admit the refrigerant carrier, before the refrigerant carrier leaks out, the inert gas itself flows from within the tightly closed housing via the minute through-holes into the cooling structure by the pressure thereof, whereby the leakage of the cooling water into the tightly closed housing can be prevented by detecting the gas contained in the refrigerant carrier or a gas flow.

The gas inlet for introducing the gas into the housing is provided, whereby the gas flows in or diffuses via the through-holes formed, as described above, due to the corrosion. As a result, the gas permeates into the refrigerant carrier with difficulty. It is therefore possible to prevent the refrigerant carrier from leaking out, if the permeated gas is detected. The gas introduced into the housing may have a pressure equal to that of the refrigerant carrier.

The gas extracting tank disposed in a cooling water circulating system functions to collect the inert gas flowing into the cooling structure, i.e., the cooling water. More specifically, the gas extracting tank interior is invariably depressurized down to an atmospheric pressure or under by means of a vacuum pump. Accordingly, the inert gas flowing into the cooling structure as well as into the cooling water is degassed and collected in the gas extracting tank the interior of which is depressurized when passing through the cooling water circulating system.

The inert gas sensor provided in the gas extracting tank functions to detect the inert gas existing in the gas extracting tank, thereby making it possible to recognize that the through-holes are formed in the cooling structure. In response to a gas detecting signal transmitted from the inert gas sensor, the operation of the semiconductor element is stopped by a control unit interlocking with the inert gas sensor, or alternatively the information is given as an alarm, thus preventing the leakage of the refrigerant carrier to hinder occurrence of a serious accident.

Detecting the formation of through-holes involves a variety of practicable manners. Such detection can also, however, be attained by detecting the variations in internal pressure of the housing or in pressure of the refrigerant carrier.

An inert gas supplying nozzle formed in the tightly closed housing is connected via an electromagnetic valve to a gas bomb. The nozzle performs functions to prevent a drop in pressure of the inert gas within the housing and constantly keep the inert gas at a higher pressure than that of the cooling water, if the inert gas existing in the tightly closed housing flows via the formed minute through-holes into the cooling structure. That is, when the minute through-holes are formed in the cooling structure and the inert gas flows thereinto, the pressure of the inert gas in the housing drops down. The inert gas running into the cooling structure is, however, quickly collected in the gas extracting tank of the cooling water circulating system, which is detected by the inert gas sensor. Then, the electromagnetic valve is actuated through a control unit. Subsequently, the inert gas is immediately fed from the inert gas bomb via the inert gas supplying nozzle into the tightly closed housing, with the result that the pressure of the inert gas in the housing is prevented from decreasing under the cooling water pressure. Thus, the internal pressure of the tightly closed housing is retained, thereby preventing the leakage of the cooling water.

The gas employed in the present invention is preferably an inert gas, and may in particular involve the use of helium, argon, neon and krypton nitrogen. Practically the most desirable inert gas is helium in terms of the requirements that gas molecules be quite small and the minute pin-holes can be detected, or in terms of considering the gas sensor.

In the above-described manner, it is possible to prevent the liquid refrigerant carrier from leaking out of the cooling structure and its connecting portion. A preparatory semiconductor module is provided for replacement or repair of that portion without stopping the computer. Even if the through-holes are formed because of the corrosion, the refrigerant carrier does not leak out immediately. In the meantime, the computer may be stopped without promtitude. This does not lead to a serious accident, and countermeasures can be taken.

As discussed above, the arrangement that the housing is formed with the gas inlet permits the operation of checking defects of the cooling structure and the bonded parts thereof. Especially, the method of detecting the first gas leaking from within the cooling structure which has previously sealed the same gas therein by introducing the gas from the gas inlet to the gas sensor is preferable, because the examination can be effected without causing the deformation of the cooling structure from a viewpoint of strength in the case of internal pressure.

[Brief Description of Drawings]

Other objects and advantages will become apparent from the following discussion taken in conjunction with the accompanying drawings, wherein:

FIGS. 1 to 3 are vertical sectional views each illustrating a semiconductor module in one embodiment of the present invention; and

FIG. 4 is a systematic diagram depicting a computer equipped with a cooling system of an electronic device composed of the semiconductor module shown in FIGS. 1 to 3.

[Best Mode for Carrying Out the Invention]

[Embodiment 1]

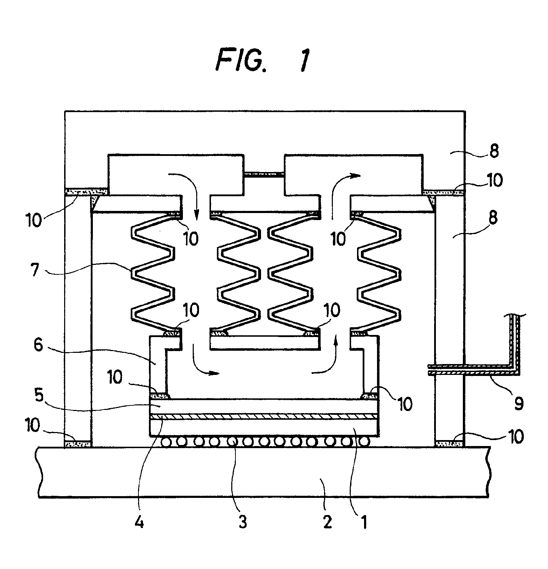

Turning first to FIG. 1, there is illustrated a sectional view of a semiconductor module in one embodiment of the present invention.

A semiconductor chip generally designated at 1 is bonded to a multilayer printed substrate 2 formed of ceramics or the like with ball solders 3. The multilayer printed substrate 2 is fitted at its end with a terminal connected to a connector provided on a mother board. Fixed on an upper face of the semiconductor chip 1 is a cooling plate 5 through a heat conductive paste 4 having flexibility enough to follow thermal deformation concomitant with emission of heat of the semiconductor chip 1. Instead of the heat conductive paste, the cooling plate may be bonded by soldering. The multilayer printed substrate 2 may involve the use of a mullite sinter. A cap 6 which admits the cooling water is fixed to the cooling plate 5 with a solder 10. A lower end of a flexible metal bellows 7 is bonded to the cap 6 with the solder 10; and an upper end thereof is fixed to a housing 10 with the solder 10, the housing being fixed beforehand to the substrate 2 with the solder 10. The housing 8 has a two-dividable structure in which after the substrate 2, the semiconductor chip 1 and the cooling structure have been formed into one united body, an upper part of the housing 8 is finally bonded thereto with the solder 10. Connected to a lower part of the housing 8 is a helium gas supplying nozzle 9 from which the helium gas is introduced. In particular, the helium gas can be kept at a higher pressure than that of the cooling water within the tightly closed housing 8.

The helium gas contained in the tightly closed housing which hermetically seals the semiconductor chip 1 and the cooling structure as well is constantly held at the higher pressure than that of the cooling water within the cooling structure. With this arrangement, if minute through-holes are formed due to corrosion of the cooling structure or exfoliation of bonded parts, the helium gas acts to prevent the leakage of the cooling water outwardly of the cooling structure. Besides, in accordance with the present invention, it is obvious that the corrosion of the cooling structure and the bonded parts thereof can be detected at such a stage that the pin-holes are still small to hinder the leakage of the refrigerant carrier.

Ceramics having high thermal conduction is employed for the cooling plate 5. The ceramics include silicon carbide, aluminum nitride, silicon nitride and alumina. The former non-oxide ceramics preferably have a thermal conductivity of 0.1 cal/cm.sec.°C or above at room temperature. Particularly, the silicon carbide and the aluminum nitride exhibit a thermal conductivity of 0.2 cal/cm.sec.°C or above; and those including BeO, $Be^2C$ and $Be^2N$ each containing Be of 3% by weight exhibit a still higher thermal conductivity. In this embodiment, a SiC sintered body containing BeO of 1% is used. The SiC sintered body has a thermal conductivity of approximately 0.5 cal/cm.sec.°C at room temperature.

Two pieces of metal bellows 7 are employed for every semiconductor chip 1. The production of the metal bellows 7 is based on electro-deposition or laminate plastic processing. Furthermore, the metal bellows 7 can be manufactured in such a way that after obtaining a given ring-like configuration by etching laminates, the laminates are so superposed as to bond their end faces to each other by diffusion bonding and by soldering. The metal bellows 7 may be composed of a Ni plate, a Ti plate and an austenite stainless steel plate which each have high anticorrosion. Especially, these plates rank in terms of degree of anticorrosion such as: Ti > Ni > stainless steel. Hence, the higher anticorrosive material is selected. The metal bellows 7 has a flexible structure to impart no thermal stress to the semiconductor chip 1 and is formed of a tabular member which is as thin as possible. A thickness of the tabular member is preferably 50 μm or less. The semiconductor chip 1 is CCB-bonded to an intermediate carrier substrate composed of a sintered body similar to the multilayer printed substrate 2; and the carrier substrate can be in turn CCB-bonded to the multilayer printed substrate. A resin containing rubber particles or inorganic particles are sealed in a bonded part between the chip 1 and the carrier substrate, thus bonding them.

In the example given above, the gas supplying port 9 is formed, and a hermetically sealed gas by pressurization can be held within the housing 8. Hermetic sealing of the gas entails a gas pressurizing method. The pressurized gas permeates into the refrigerant carrier via pin-holes formed due to the corrosion of the metla bellows 7 and bonded parts 10. The pin-holes can be detected by means of a gas sensor for the gas contained therein, or from variations in pressure which are shown by a pressure gauge incorporated into the housing 8.

[Embodiment 2]

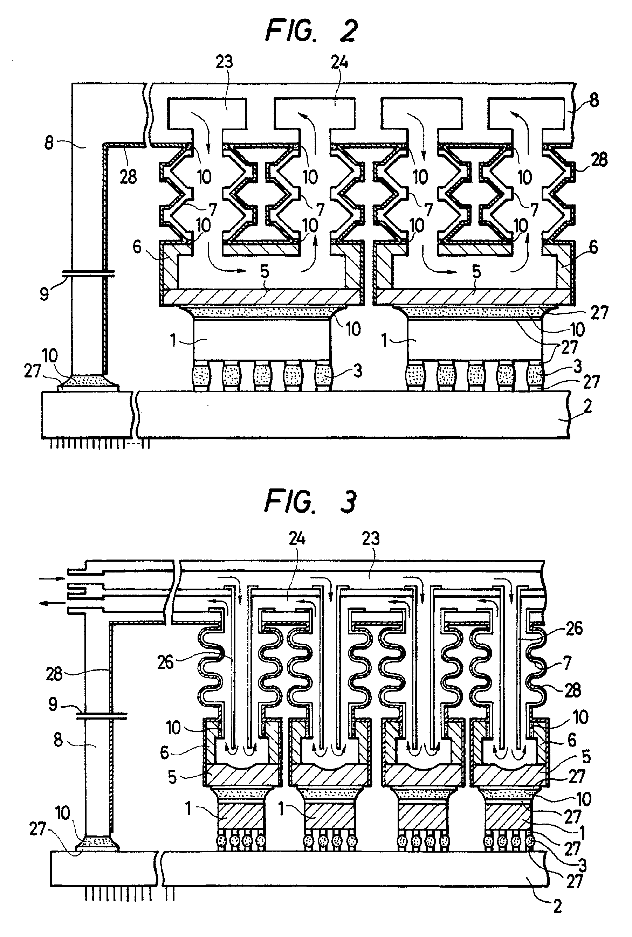

FIG. 2 depicts an arrangement in which a plurality of semiconductor chips 1 and of cooling structures are packaged in the same housing. The arrangement of a second embodiment is fundamentally the same except that the plurality of semiconductor chips 1 are packaged in the same housing. However, an improvement in tangible structure is added to the second embodiment.

Referring again to FIG. 2, a ceiling wall of the housing 8 is formed with 2-staged water supply/ discharge passageways 23 and 24. The metal bellows 7 manufactured by diffusion bonding is soldered to a module interior of the housing 8. Soldered to the top of the metal bellows 7 is a cooling block consisting of a metal cap 6 and a ceramic plate 5 which is defined as an electric insulator and has a good thermal conductivity. The interior of the metal bellows 7 is fed with the cooling water via the water supplying passageway, and the cooling water passing through the bellows interior and the water discharging passageway 24 is then discharged to a water discharge port. A ceramic plate 5 of the cap 6 and the LSI chips 1 are solderconnected 10 through metallized films 27. The LSI chips 1 are mounted on the multilayer wiring substrate 2 by the solder-connection. A skirt lower end of the housing 8 is hermetically bonded to the multilayer wiring substrate 2 with a low-melting solder 10. In the module interior, surfaces of the housing and the cooling structure consisting of the bellows 7 and the cap 6 are coated with moisture permeable organic thin films 28 formed by a vacuum vapor deposition method. Excepting the vacuum vapor deposition, a practical method of coating the thin film may include an electrode method in which polymerization is effected by applying an voltage while being immersed in a monomer liquid, and a method in which the polymerization is effected by heating after being immersed in the monomer liquid diluted by a solvent.

In the second embodiment, the metal bellows 7 is composed of a Ni material which is approximately 30 μm in thickness.

The helium gas is introduced by pressurization from the supply port 9, and the interior of the housing 8 is kept at a high pressure. It is feasible to prevent the water leakage through the pin-holes caused by the corrosion of the metal bellows 7 and the solders 10 in this embodiment, too. [Embodiment 3]

FIG. 3 illustrates an arrangement in which a plurality of semiconductor chips 1 are packaged in the housing 8. The arrangement is substantially the same as that of the embodiment 2 except that a means for supplying and discharging the cooling water is different from the second embodiment. The metal bellows 7 is manufactured to have a thickness of about 30 μm by performing Ni electrodeposition. The cooling water is supplied through a pipe 26, but is discharged along the outside of the pipe 26. A single piece of metal bellows 7 is provided on each semiconductor chip 1.

In the third embodiment, the helium gas is likewise introduced by pressurization from the helium supplying port 9, whereby the housing interior can be held at a high pressure. As a result, it is possible to prevent the leakage of the refrigerant carrier which is associated with the formation of pin-holes due to the corrosion of the metal bellows 7 and the solders 10. [Embodiment 4]

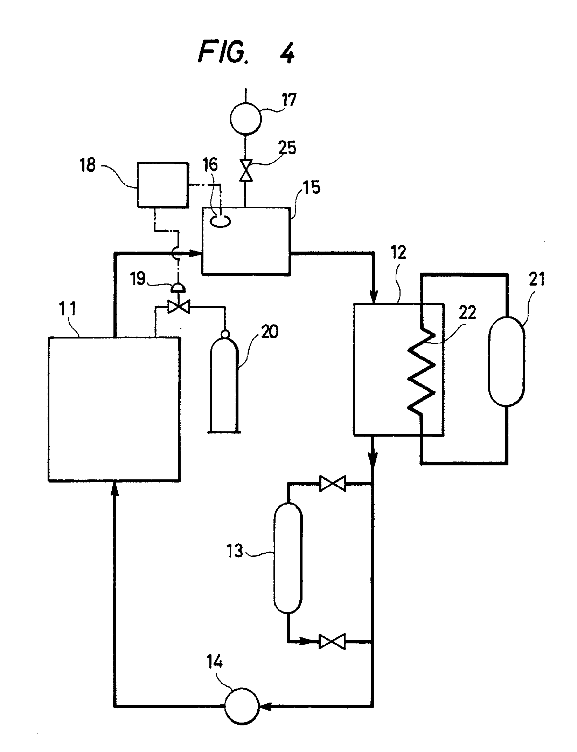

FIG. 4 is a systematic diagram depicting a computer equipped with a maintenance system or a cooling system of an electronic device employing the semiconductor module of the invention.

An electronic device 11 mounted with a plurality of semiconductor modules shown in FIG. 1 is connected to a hermetically sealed circulating cooling water system. Connected to the hermetically sealed circulating cooling water system is a cooling water tank 12 the cooling water of which is cooled by means of a freezer 21 through a heat exchanger 22. The cooling water passes through a cooling water purifying unit 13 in which to eliminate water-contained impurities determent to the corrosion of a material of the cooling structure. In this manner, the cooling water is highly purified. The cooling water which has exited the cooling water purifying unit 13 is then fed by a pump 14 to the semiconductor module of the electronic device 11 constituting the computer, thus cooling the semiconductor chips. The cooling water which has exited the electronic device 11 passes through a gas extracting tank 15 and returns to a cooling water tank 12, thus circulating in a cooling system. The semiconductor module for use is shown in FIGS. 1 to 3.

If there are formed through-holes that are as small as pin-holes which do not permit the water leakage into the cooling structure depicted in FIG. 1, as discussed above, firstly the helium gas existing in the tightly closed housing flows via the through-holes into the cooling water, thereby preventing the leakage of the cooling water into the housing. The helium gas is supplied from a helium gas bomb 20.

The helium gas flowing into the cooling water runs out of the electronic device 11 together with the cooling water and enters the gas extracting tank 15. The interior of the gas extracting tank 15 remains depressurized at a given level by means of a vacuum pump 17 through an electromagnetic valve 25. For this reason, the helium gas contained in the cooling water is degassed and trapped by the gas extracting tank 15. The gas extracting tank 15 incorporates a helium gas sensor 16 for detecting the trapped helium gas. A signal transmitted from the helium gas sensor 16 is sent to a control unit 18, and there is issued an alarm indicating that the through-holes are formed in the semiconductor module cooling structure in the electronic device 11. Simultaneously when giving the alarm, the electro-magnetic valve 19 is actuated in response to the signal from the control unit 18, and the helium gas is supplied from the helium gas bomb 20 via the helium gas supplying port into the tightly closed housing of the semiconductor module, depicted in FIG. 1, of the electronic device 11. The housing interior is thus kept at a predetermined helium gas pressure.

As described above, the cooling water circulating system is provided with the gas extracting tank incorporating the helium gas sensor 16, and the tightly closed housing of the semiconductor module has the gas supplying system including the helium gas supplying port. With this arrangement, the tightly closed housing interior is invariably charged with the helium gas having a higher pressure than that of the cooling water, thereby preventing the cooling water leakage.

As discussed above, the helium gas is detected by the helium gas sensor 16, and when the alarm is issued, the electronic device 11 ceases to operate. A portion from which the helium gas leaks is replaced, or alternatively the repair can be effected by changeover to a preparatory electronic device. [Embodiment 5]

The bonded parts are checked by using the semiconductor module of FIG. 1. The helium gas conceived as a first gas is fed into the metal bellows 7, and at the same moment argon gas defined as a second gas is introduced into the housing 8. After the air existing in both of them have all been replaced with the respective gases, a leak test for the metal bellows 7 and the bonded parts 10 is performed by pressurizing the helium gas. The gas supplying port is fitted with a helium gas sensor. When supplying the gas, the leak test is carried out by simultaneously exhausting both of them in vacuo. In this way, the bonded parts 10 based on soldering or brazing can be inspected before being used.

[Industrial Applicability]

In accordance with the present invention, it is possible to beforehand quickly detect the leakage of the cooling water of the semiconductor module equipped with the cooling structure and at the same time check the semiconductor module. Besides, electrical troubles of the semiconductor chips which are caused by the cooling water leakage can be nipped in the bud. Thus, the highly reliable semiconductor module and computer utilizing this module can be obtained.

## Claims

1. A semiconductor module comprising:
   a semiconductor element;
   a cooling structure for cooling said semiconductor element with a liquid refrigerant carrier; and
   a housing for accommodating said semiconductor element and said cooling structure as well, characterized in that said housing is filled with a gas having a higher pressure than that of said refrigerant carrier, or which is in turn sealed therein.

2. A semiconductor module comprising:
   a semiconductor element; ·
   a cooling structure for cooling said semiconductor element with a liquid refrigerant carrier; and
   a housing for accommodating said semiconductor element and said cooling structure, characterized in that said housing is formed with a gas supplying port.

3. A method of cooling a semiconductor module including a semiconductor element, a cooling structure for cooling said semiconductor element with a liquid refrigerant carrier, and a housing for accommodating said semiconductor element and said cooling structure, comprising the steps of:
   detecting corrosion of said cooling structure and bonded parts thereof which is associated with said refrigerant carrier at such a minute pin-hole stage that said refrigerant carrier does not flow out therefrom; and
   preventing said refrigerant carrier from leaking outwardly of said cooling structure.

4. A semiconductor module cooling system comprising:
   a semiconductor module including a semiconductor element, a cooling structure for cooling said semiconductor element with a liquid refrigerant carrier, and a housing for accommodating said semiconductor element and said cooling structure;
   a refrigerant carrier supplying means for supplying said liquid refrigerant carrier to said cooling structure; and
   a gas supplying means for supplying an interior of said housing with a gas.

5. A semiconductor module cooling system comprising:
   a semiconductor module including a semiconductor element, a cooling structure for cooling said semiconductor element with a liquid refrigerant carrier, and a housing for accommodating said semiconductor element and said cooling structure;

a refrigerant carrier supplying means for supplying said refrigerant carrier to said cooling structure; and

a means for detecting a gas leakage into said cooling structure.

6. A semiconductor module cooling system comprising: a semiconductor module including a semiconductor element, a cooling structure for cooling said semiconductor element with a liquid refrigerant carrier, and a housing for accommodating said semiconductor element and said cooling structure;

a refrigerant carrier supplying means for supplying said liquid refrigerant carrier to said cooling structure;

a gas supplying means for supplying said housing with a gas having a higher pressure than that of said liquid refrigerant carrier; and

a sensor for detecting said gas contained in said refrigerant carrier which has been discharged from said cooling structure.

7. In a semiconductor module cooling system having a semiconductor module including a semiconductor element, a cooling structure for cooling said semiconductor element with a liquid refrigerant carrier, and a housing for accommodating said semiconductor element and said cooling structure,

an improvement characterized by comprising:

a means for detecting pin-holes formed due to corrosion in parts, which are in contact with said liquid refrigerant carrier, of said cooling structure and of connecting portions between said cooling structure and other members before said liquid refrigerant carrier leaks outside said cooling structure.

8. In a semiconductor module cooling system having a semiconductor element, a cooling structure for cooling said semiconductor element with a liquid refrigerant carrier, and a housing for hermetically sealing said semiconductor element and said cooling structure,

an improvement characterized in that said semiconductor module comprises a means for detecting variations in pressure within said housing or said cooling structure.

9. A semiconductor module maintenance system comprising:

a semiconductor element;

a cooling structure for cooling said semi- conductor element with a liquid refrigerant carrier; and

a housing for accommodating said semiconductor element and said cooling structure, characterized in that a gas contained in said refrigerant carrier leaking from said cooling structure is detected, and said semiconductor element ceases to operate in advance of a leakage of said refrigerant carrier into said housing.

10. A semiconductor module maintenance system comprising:

a semiconductor element;

a cooling structure for cooling said semiconductor element with a liquid refrigerant carrier; and

a housing for accommodating said semiconductor element and said cooling structure, characterized in that there is further provided a refrigerant carrier leakage alarming means for detecting a gas leakage into said cooling structure and issuing an alarm.

11. In a computer having:

a semiconductor module including a semiconductor element, a cooling structure for cooling said semiconductor element with a liquid refrigerant carrier, and a housing for hermetically sealing said semiconductor element and said cooling structure;

a heat exchanger for effecting a heat exchange with other refrigerant carriers for cooling said liquid refrigerant carriers

a circulation pump for forcibly circulating said liquid refrigerant carrier; and

a purifying unit for purifying said liquid refrigerant carrier,

an improvement characterized by comprising:

a gas supplying means for keeping a gas at a higher pressure than that of said liquid refrigerant carrier in said housing;

a gas extracting tank for extracting the gas which has permeated into said liquid refrigerant carrier; and

a gas sensor for detecting the extracted gas.

12. The computer as set forth in Claim 7, wherein an arrangement of said cooling structure is that a cooling plate connected by a laminate bellows is brought into contact with or connected to said semiconductor element which is then cooled by circulating said refrigerant carrier within said bellows.

13. A method of checking a semiconductor module including a semiconductor element, a cooling structure for cooling said semiconductor element with a liquid refrigerant carrier, and a housing for accommodating said semiconductor element and said cooling structure, comprising the steps of:

injecting a gas into said cooling structure or said housing; and

detecting pin-holes formed in said structure by detecting a gas leakage into said cooling structure or said housing.

14. A method of checking a semiconductor module including a semiconductor element, a cooling structure for cooling said semiconductor element with a liquid refrigerant carrier, and a housing for accommodating said semiconductor element and said cooling structure, comprising the steps of:

injecting a first gas into said cooling structure and a second gas into said housing, respectively; and

detecting pin-holes formed in said cooling structure by detecting a leakage of any one of said first and second gases.

15. The method as set forth in Claim 14, wherein leakages of said first and second gases are detected.

16. A semiconductor module comprising:

a semiconductor element;

a cooling structure for cooling said semiconductor element with a liquid refrigerant carrier; and

a housing for accommodating said semiconductor element and said cooling structure, characterized in that a gas fills said housing or is sealed therein, and said cooling structure is formed of a bellows having a thickness of 30 $\mu$m or less.

# FIG. 1

## FIG. 2

## FIG. 3

# FIG. 4

# INTERNATIONAL SEARCH REPORT

International Application No  PCT/JP88/00358

## I. CLASSIFICATION OF SUBJECT MATTER (if several classification symbols apply, indicate all) 6

According to International Patent Classification (IPC) or to both National Classification and IPC

Int.Cl⁴  G06F1/00, H01L23/46

## II. FIELDS SEARCHED

### Minimum Documentation Searched 7

| Classification System | Classification Symbols |
|---|---|
| IPC | G06F1/00, H01L23/34-23/46 |

### Documentation Searched other than Minimum Documentation to the Extent that such Documents are Included in the Fields Searched 8

| | |
|---|---|
| Jitsuyo Shinan Koho | 1967 - 1987 |
| Kokai Jitsuyo Shinan Koho | 1971 - 1987 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | JP, A, 54-44479 (International Business Machines Corp.) 7 April 1979 (07. 04. 79) & US, A, 4138692 & EP, A1, 1123 & CA, A1, 1097788 & JP, B4, 56-31743 & EP, B1, 1123 | 1-16 |

* Special categories of cited documents: 10

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

## IV. CERTIFICATION

| Date of the Actual Completion of the International Search | Date of Mailing of this International Search Report |
|---|---|
| June 27, 1988 (27. 06. 88) | July 11, 1988 (11. 07. 88) |

| International Searching Authority | Signature of Authorized Officer |
|---|---|
| Japanese Patent Office | |

Form PCT/ISA/210 (second sheet) (January 1985)